# EUROPEAN PATENT APPLICATION

(11) **EP 1 391 969 A2**
(43) Date of publication of application: **25.02.2004**
(21) Application number: 03018849.4
(22) Date of filing: 19.08.2003
(51) Int. Cl.: H01R 13/03

(54) **Terminal with Ruthenium Layer and part having the same**

(30) Priority: 22.08.2002 JP 2002242150; 26.11.2002 JP 2002342157; 09.12.2002 JP 2002356706
(71) Applicant: FCM Co., Ltd., Osaka-shi, Osaka (JP)
(72) Inventor: Miura, Shigeki, Osaka-shi, Osaka (JP)
(74) Representative: Grünecker, Kinkeldey, Stockmair & Schwanhäusser Anwaltssozietät

(57) **Abstract**

A terminal of the present invention includes a ruthenium layer (102) formed on conductive substrate (101) entirely or partially, and a surface metal layer (103) made of at least one of the metals selected from the group consisting of Au, Pt, Ag, Pd, Rh, Co, Ni, In and Sn, or made of an alloy containing at least one of the metals selected from the group, which is formed on the ruthenium layer (102) entirely or partially.

## Description

### BACKGROUND OF THE INVENTION

### Field of the Invention

The present invention relates to a terminal widely used for a connection in an electric or an electronic product, a semiconductor product, an automobile part and the like (for example, a connector terminal, a relay terminal, a slide switch terminal, a soldering terminal and the like). More specifically, the present invention relates to a terminal especially suitable for an application where ease of mating/unmating, resistance to heat, resistance to corrosion, and high hardness are required (including both applications for mating/unmating and not for mating/unmating) and a part having the terminal (for example, a connector, a relay, a slide switch and the like).

### Description of the Background Art

Conventionally, various terminals including a connector terminal have been used for an electric or an electronic product, a semiconductor product, an automobile part and the like. In an application where reliability of connection is specifically required, a commonly employed structure is to form an Ni layer on a conductive substrate and to form a thin gold layer thereon. In this structure, however, due to relatively low hardness of both of the Ni layer and the gold layer, the gold layer is easily scratched or fallen off undesirably, which poses a serious problem especially under high temperature. This problem is incurred, especially when the terminal is a connector terminal, by repeated mating and unmating of the connector.

This problem is not limited to degradation in the appearance, and it invites a critical problem that when the gold layer is fallen off to expose the Ni layer, the Ni layer is easily oxidized and contact electric resistance (hereinafter simply referred to as contact resistance) rises extremely.

It may be contemplated to increase the thickness of the gold layer to overcome the problem. However, thickening gold layer not only increases the cost, but also poses another problem that it becomes easier to be scratched off and attains adhesiveness against the original intention, and thus the problem can not be overcome with this means. In special, when the terminal is a connector terminal, such a thickened gold layer increases the contact friction in mating and unmating and reduces the ease of mating and unmating.

Another problem is that, in a terminal having the structure above, where the Ni layer and the gold layer are formed on the conductive substrate, a pinhole easily occurs in the Ni layer through which the conductive substrate and the gold layer directly contact to each other, which results in a galvanic corrosion due to the difference between their ionization tendencies. This problem is obvious especially when the conductive substrate is made of copper or copper alloy.

Some elements are proposed to be used as such a terminal recently, but no element that directly solves the problems above is known.

For example, Japanese Patent Laying Open No. 2001-152385 discloses an electric product useful as an electric connector in which an amorphous metal lower layer, a metal intermediate layer and a noble metal external layer are successively deposited on a metal substrate. It is described that the amorphous metal lower layer and the metal intermediate layer are formed in order to prevent corrosion of the metal substrate, since the noble metal external layer is porous and therefore cannot prevent the corrosion of the metal substrate by itself. However, this reference is silent about the problem of the noble metal external layer (i.e., the gold layer) being fallen off as described above, and therefore it does not suggest means to solve such a problem.

Japanese Patent Laying Open No. 2000-222960 discloses an electric contact material in which one of Au, Ag, Pd, Rh, Ru, Pt, Ni, and Sn or an alloy thereof is covered on an electric contact part on a conductive band-form element and an insulating resin is coated on surrounding part that is not the electric contact part. It is described that the insulating resin is formed in order to prevent sulfuration creep from occurring in the vicinity of electric contact part. However, this reference is also silent about the problem of the gold layer being fallen off as described above, and therefore it does not suggest means to solve such a problem.

Further, Japanese Patent Laying Open No. 11-260178 discloses a switch contact in which a ruthenium oxide layer is formed on a conductive substrate, and a noble metal layer is formed thereon. However, this reference is also silent about the problem of the gold layer being fallen off as described above, and therefore it does not suggest means to solve such a problem.

### SUMMARY OF THE INVENTION

The present invention is directed to solve the problems above, and an object of the present invention is to provide a terminal enabling easier mating/unmating and having excellent contact resistance without removal of the surface layer, as well as having resistance to heat, resistance to corrosion and high hardness, and to provide a part having such a terminal.

The present inventor studied to solve the problems above, and came to know that not only the effect of a surface metal layer but also that of the layer under the surface metal layer are important in order to improve ease of mating/unmating, resistance to heat and corrosion, while maintaining excellent contact resistance of a metal layer. On the basis of such findings, the inventor further studied the problems and eventually made the present invention.

Specifically, the terminal of the present invention is characterized in that it has a ruthenium layer formed on a conductive substrate partially or entirely, and a surface metal layer made of at least one of metals selected from the group consisting of Au, Pt, Ag, Pd, Rh, Co, Ni, In and Sn, or an alloy containing at least one of the metals is formed partially or entirely on the ruthenium layer.

Preferably, the ruthenium layer is made of metal ruthenium or an alloy containing ruthenium, and the surface metal layer is a gold layer made of metal gold (Au). Further, preferably the terminal is any one of a connector terminal, a relay terminal, a slide switch terminal or a soldering terminal.

By positioning the ruthenium layer as the under layer of the surface metal layer as above, the ruthenium layer and the surface metal layer interact with each other to effectively prevent wear or removal of the surface metal layer, to obtain excellent ease of mating/unmating while maintaining excellent contact resistance of the surface metal layer, and to effectively prevent the occurrence of a pinhole. Thus, the quality such as high hardness, and resistance to heat and corrosion is drastically improved.

Further, the terminal of the present invention can be formed in a structure in which two or more surface metal layers of different compositions are formed. Thus, the application of the terminal of the present invention including a connector terminal can be widened.

Still further, the terminal of the present invention can be formed in a structure in which at least one ground layer made of at least one of the metals selected from the group consisting of Ni, Cu, Au and Ag, or an alloy containing at least one of the metals is formed between the conductive substrate and the ruthenium layer. Though the ruthenium layer itself has high hardness, the stress is large. Thus, the ruthenium layer may be removed from the conductive substrate depending on the type of the conductive substrate. The specific ground layer is formed to alleviate such a phenomenon.

In the present invention, it is preferable that the ground layer, the ruthenium layer and the surface metal layer are formed by a plating method using any one of a barrel plating apparatus, a rack plating apparatus and a continuous plating apparatus. Thus, these layers can be efficiently formed.

Further, a part of the present invention has the terminal described above. Thus, the part attains excellent contact resistance, ease of mating/unmating, high hardness, resistance to heat, and resistance to corrosion, and attains extremely high reliability. Here, such a part is preferably any one of a connector, a relay, a slide switch, a resistor, a condenser, a coil and a substrate.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross-sectional view of a terminal in which a ruthenium layer and a surface metal layer are formed on a conductive substrate in this order;
Fig. 2 is a schematic cross-sectional view of a terminal in which a ground layer, a ruthenium layer and a surface metal layer are formed on a conductive substrate in this order;
Fig. 3 is a schematic cross-sectional view of a terminal in which a plurality of ground layers, a ruthenium layer and a surface metal layer are formed on a conductive substrate in this order; and
Fig. 4 is a schematic cross-sectional view of a terminal in which a ruthenium layer is formed on a conductive substrate, and a plurality of surface metal layers are formed thereon.

### DESCRIPTION OF THE PREFERRED EMBODIMENTS

### Conductive Substrate

For the conductive substrate of the present invention, any conductive substrate may be employed, as long as it is conventionally known and used for an electric or an electronic product, a semiconductor product, an automobile part and the like. Examples of such a conductive substrate are copper (Cu), copper alloy base material such as phosphor bronze, brass, beryllium copper, titanium copper, and nickel silver (Cu-Ni-Zn), iron Fe), iron alloy base material such as Fe-Ni alloy and stainless steel, nickel base material and copper patterns on various substrates. It should be noted that the shape of the conductive substrate is not limited to platy shape, for example, such as tape-like shape, and it includes bulky shape such as a press molding product and any other shape.

### Ruthenium Layer

The ruthenium layer of the present invention is formed on the conductive substrate above entirely or partially, and made of metal ruthenium (Ru) singularly or made of an alloy containing ruthenium. Example of the alloy including ruthenium is the one containing at most 30 weight % of palladium (Pd) or nickel (Ni). Normally, it is not necessary to alloy ruthenium for use due to its high hardness and excellent resistance to corrosion. In some cases where stress must be lowered or higher priority is given to costs than strong resistance to corrosion; as will be described below, it may be preferable to use ruthenium as being alloyed.

When such a ruthenium layer is made of metal ruthenium (Ru), it is formed by plating on the conductive substrate, in a thickness ranging from 0.05 to 1.5 µm, preferably from 0.2 to 1.0 µm. When such a ruthenium layer is made of an alloy containing ruthenium, it is formed by plating on the conductive substrate in a thickness ranging from 0.05 to 3 µm, preferably from 0.5 to 1.5 µm. The layer can be made thicker with an alloy than with metal ruthenium due to the lower stress of an alloy.

The partial formation of the ruthenium layer on the conductive substrate includes cases where the layer is formed on either one of the surfaces of the conductive substrate, i.e., the upper or lower surface, and where the layer is formed on specified part of the surfaces. As a formation method of ruthenium layer, conventional method can be adopted, such as a plating bath liquid surface adjusting method, a masking method, a mechanical mask method, a belt method, or a brush method.

When such a ruthenium layer is made of metal ruthenium (Ru), if the thickness is less than 0.05 µm, the interaction with the layer and a surface metal layer, which will be described later, can not be fully attained, and if the thickness is more than 1.5 µm, the stress of the ruthenium layer itself becomes excessively great that the ruthenium layer falls off from the conductive substrate or cracks occur therein undesirably. The ruthenium layer has high hardness and excellent resistance to oxidation. Further, even when it is oxidized, the oxide shows high conductivity of 10⁻⁶ S/m (for comparison, the conductivity of Ni oxide is 10¹¹ S/m). The synergistic effect among these characteristics is considered to contribute to higher interaction between the ruthenium layer and the surface metal layer described below.

### Surface Metal Layer

The surface metal layer of the present invention have a dominant role in applying conductivity to a terminal, and formed on the ruthenium layer entirely or partially. It is made of at least one of the metals selected from the group consisting of Au, Pt, Ag, Pd, Rh, Co, Ni, In and Sn, or of an alloy containing at least one of the metals. As a surface metal layer, a gold layer made of metal gold (Au) is preferable. Further, as the surface metal layer, two or more layers having different compositions from each other may be formed.

Here, the composition of the alloy is not specifically limited as long as it contains at least one of the metals listed above. Examples of the alloy include an alloy containing at least 50 weight % and at most 99.99 weight %, preferably at least 50 weight % and at most 99.9 weight %; and more preferably at least 50 weight % and at most 99.8 weight % of one of the listed metals. A suitable example of the alloy may specifically be a gold alloy, since Pd or Rh in the group above have high hardness and hence do not provide an advantage to be used for the alloy in sight of hardness, whereas gold (Au) has low hardness and hence it is preferable to be alloyed to achieve high hardness. Examples of the gold alloy include alloys of gold and cobalt (Co), nickel (Ni), indium (In) and the like. Here, the content of the gold may be in the range described above.

When forming two or more layers of different compositions as the surface metal layer, the exemplary manner is to form a gold or gold alloy layer as described above on any part of the ruthenium layer, and to form on the another part tin (Sn) or tin alloy (for example, Sn-Ag alloy, Sn-Cu alloy, Sn-Pb alloy, Sn-Zn alloy, and Sn-Bi alloy). In this case, as described above the gold or gold alloy layer has a dominant role in applying conductivity, while the tin or tin alloy layer has a role of soldering.

Such a surface metal layer is usually formed by plating the metal or the alloy above on the ruthenium layer in a thickness of 0.001-2 µm, preferably 0.1-0.5 µm. If the thickness is less than 0.001 µm, excellent contact resistance can not be obtained, and if the thickness is more than 2 µm, not only the cost increases but also the interaction between the ruthenium layer can not be attained, and thus not preferable. It should be noted that, when the surface metal layer is formed in the purpose of soldering, the thickness must be 0.5-10 µm. As for the method of forming the surface metal layer on the ruthenium layer partially, conventionally known method such as a plating bath liquid surface adjusting method, a masking method, a mechanical mask method, a belt method, and a brush method can be adopted.

### Ground Layer

The ground layer of the present invention is formed as necessary when the ruthenium layer described above tends to fall off depending on the type of the conductive substrate. Normally, the ruthenium layer hardly falls off due to its stress when the conductive substrate is made of a nickel base material. On the other hand, when the conductive substrate is made of a material other than a nickel base material, it tends to fall off easily, in which case the ground layer must be formed.

Thus, the ground layer has an effect of preventing the ruthenium layer from falling off. Therefore, the ground layer is formed between the conductive substrate and the ruthenium layer (i.e., as the lower layer of the ruthenium layer), and it is a layer made of at least one of the metals selected from the group consisting of Ni, Cu, Au and Ag or made of an alloy containing at least one of the metals, and it is formed as at least one layer (i.e., as a single layer or a plurality of layers). As used herein, the composition of the alloy is not limited specifically as long as it contains at least one of the metals above. For example, it may be an alloy containing at least 50 weight % of one of the metals above.

When forming a plurality of ground layers, it is preferable to determine the type of the metal or the alloy or the thickness forming each layer, considering the thickness of the ruthenium layer or the type of the conductive substrate. For example, when the conductive substrate is made of a copper alloy base material, it is preferable to form a first ground layer made of Ni having a thickness of 0.05-5 µm on the conductive substrate, and to form a second ground layer made of Au or Ag having a thickness of 0.05-3 µm thereon. When the conductive substrate is an iron base material or brass, it is preferable to form a first ground layer made of Cu having a thickness of 0.05-5 µm on the conductive substrate, and to form a second ground layer made of Ni having a thickness of 0.05-2 µm thereon.

Thus, the ground layer may be formed by plating each of the metals or alloys on the conductive substrate normally as a single layer or as a plurality of layers having a thickness of 0.05-7 µm, preferably 0.8-4.0 µm. If the thickness of the ground layer is less than 0.05 µm, the ruthenium layer can not be prevented from falling off, and if the thickness is more than 7 µm, not only the cost increases and hence disadvantageous economically, but also the thickness changes by time, i.e., stability of its size can not be attained. Additionally, it is not preferable since the conductive substrate loses its spring.

### Terminal

The terminal of the present invention has a structure in which each layer above is formed on the conductive substrate. The shape or the structure of the terminal is not specifically limited as long as it has such a structure. When the terminal is a connector terminal, it may be a female terminal or a male terminal.

The application of the terminal of the present invention includes both applications for mating/unmating and not for mating/unmating, and it includes specifically a connector terminal, a relay terminal, a slide switch terminal, and a soldering terminal.

### Part

The part of the present invention has the terminal described above. Examples of the part include, an electric and an electronic part, a semiconductor part, an automobile part and the like that are used as a connector, a relay, a slide switch, a resistor, a condenser, a coil, and a substrate, but the part is not limited thereto and the shape thereof is not specified.

In special, when the part of the present invention is a connector, it is not limited to a normal connector as long as it has the connector terminal above, and a pattern on the circuit board and the like may be included as well. The application of such a connector is wide and includes, for example, an electric part, an electronic part, a semiconductor part, and an automobile part. The shape thereof is not specified as long as it is capable of mating/unmating and used for a purpose of electrical connection.

### Manufacturing Apparatus

As described above, the ground layer, the ruthenium layer and the surface metal layer are normally formed by a plating method, which is specifically preferable to be carried out using any one of a barrel plating apparatus, a rack plating apparatus, and a continuous plating apparatus. By using these apparatuses, the terminal can be manufactured highly efficiently.

Here, the barrel plating apparatus is an apparatus that plates terminals one by one individually, the continuous plating apparatus is an apparatus that plates a plurality of terminals at once continuously, and the rack plating apparatus is an intermediate apparatus between the two, having a middle-scale manufacturing efficiency. These apparatuses are well known in the field of plating, and any of the structure of which may be employed as long as it is known in the art.

In the following, while the present invention will be described in detail referring to examples, it is not limited thereto.

### Example 1

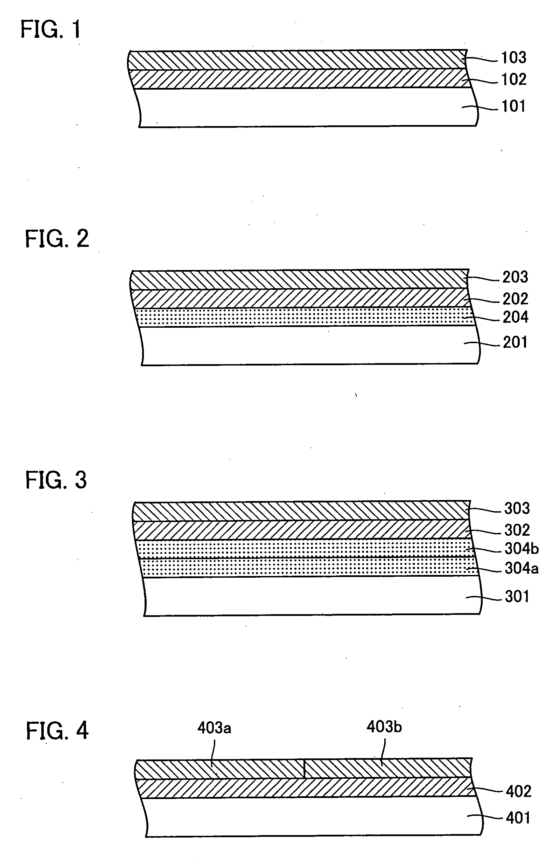

The present example relates to a connector terminal in which a ruthenium layer and a gold layer as a surface metal layer are formed in this order on a conductive substrate. In the following, description will be given referring to Fig. 1.

First, as a conductive substrate 101, a tape-like nickel having a thickness of 0.1 mm is pressed into a shape of a connector to be a continuing connector terminal, and cut to have a length of 70 mm. After the cutting, degreasing process was carried out by cleaning conductive substrate 101 for three minutes at 53°C using 50 g/l of a surfactant (product name: ACE CLEAN 30, available from Okuno Chemical Industries Co., Ltd.). Then, after rinsing with water for several times, electrolytic degreasing process was further carried out by cleaning it for two minutes, under a condition of 50°C and current density 5.0 A/dm², using 100 g/l of a surfactant (product name: NC Lastoru, available from Okuno Chemical Industries Co., Ltd.). Then, after rinsing with water for several times, an activation process by acid was carried out by processing it using 5% of sulfuric acid for one minute at 25°C. Thereafter, it was rinsed with water for several times.

Next, a conductive substrate 101 thus processed was electroplated by a rack plating apparatus for five minutes under a condition of 60°C, pH 2.0, current density 1.5 A/dm², using ruthenium plating liquid (product name: Ru-33, available from NE Chemcat Corporation) of ruthenium concentration 8 g/l, to obtain a ruthenium layer 102 made of metal Ru having a thickness of 0.4 µm thereon.

Then, after rinsing with water for several times, it was further rinsed with 10% ammonia water (at 50°C for five minutes). Thereafter, an activation process by acid was carried out by processing it using 10% of hydrochloric acid for 0.5 minute at 25°C.

Next, after rinsing with water for several times, ruthenium layer 102 thus processed was electroplated by a rack plating apparatus for one minute under a condition of 35°C, pH 4.1, current density 1.2 A/dm², using gold plating liquid (product name: N77, available from NE Chemcat Corporation) of gold concentration 9 g/l, to obtain a surface metal layer 103 of a gold layer made of metal Au having a thickness of 0.1 µm thereon. Thus, the connector terminal of the present invention shown in Fig. 1 was obtained.

The connector terminal thus obtained had excellent connect resistance, ease of mating/unmating, and resistance to corrosion. Accordingly, the reliability of the connector having this connector terminal was extremely high.

### Example 2

The present example relates to a connector terminal in which a ground layer, a ruthenium layer and a gold layer as a surface metal layer are formed in this order on a conductive substrate. In the following, description will be given referring to Fig. 2.

First, as a conductive substrate 201, a tape-like phosphor bronze having a thickness of 0.1 mm is pressed into a shape of a connector to be a continuing connector terminal, and cut to have a length of 70 mm. After the cutting, degreasing process was carried out by cleaning conductive substrate 201 for three minutes at 53°C using 50 g/l of a surfactant (product name: ACE CLEAN 30, available from Okuno Chemical Industries Co., Ltd.). Then, after rinsing with water for several times, electrolytic degreasing process was further carried out by cleaning it for two minutes, under a condition of 50°C and current density of 5 A/dm², using 100 g/l of a surfactant (product name: NC Lastoru, available from Okuno Chemical Industries Co., Ltd.). Then, after rinsing with water for several times, an activation process by acid was carried out by processing it using 5% of sulfuric acid for one minute at 25°C. Thereafter, it was rinsed with water for several times.

Next, conductive substrate 201 thus processed was electroplated by a rack plating apparatus for one minute under a condition of 55°C, pH 3.8, current density 4 A/dm², using nickel plating liquid (containing 240 g/l of nickel sulfate, 50 g/l of nickel chloride, and 40 g/l of boric acid), to obtain a ground layer 204 made of Ni having a thickness of 0.95 µm thereon.

After rinsing with water for several times, ground layer 204 was electroplated by the rack plating apparatus for five minutes under a condition of 60°C, pH 2.0, current density 1.5 A/dm², using ruthenium plating liquid (product name: Ru-33, available from NE Chemcat Corporation) of ruthenium concentration 8 g/l, to obtain a ruthenium layer 202 made of metal Ru having a thickness of 0.4 µm thereon.

Then, after rinsing with water for several times, it was further rinsed with 10% ammonia water (at 50°C for five minutes). Thereafter, an activation process by acid was carried out by processing it using 10% of hydrochloric acid for 0.5 minute at 25°C.

Next, after rinsing with water for several times, ruthenium layer 202 thus processed was electroplated by the rack plating apparatus for one minute under a condition of 35°C, pH 4.1, current density 1.2 A/dm², using gold plating liquid (product name: N77, available from NE Chemcat Corporation) of gold concentration 9 g/l, to obtain a surface metal layer 203 of a gold layer made of metal Au having a thickness of 0.1 µm thereon. Thus, the connector terminal of the present invention shown in Fig. 2 was obtained.

The connector terminal thus obtained had excellent connect resistance, ease of mating/unmating, and resistance to corrosion. Accordingly, the reliability of the connector having this connector terminal was extremely high.

### Example 3

The present example relates to a connector terminal in which a plurality of ground layers, a ruthenium layer and a gold layer as a surface metal layer are formed in this order on a conductive substrate. In the following, description will be given referring to Fig. 3.

First, as a conductive substrate 301, a tape-like brass having a thickness of 0.1 mm is pressed into a shape of a connector to be a continuing connector terminal, and cut to have a length of 70 mm. After the cutting, degreasing process was carried out by cleaning conductive substrate 301 for three minutes at 53 °C using 50 g/l of a surfactant (product name: ACE CLEAN 30, available from Okuno Chemical Industries Co., Ltd.). Then, after rinsing with water for several times, electrolytic degreasing process was further carried out by cleaning it for two minutes, under a condition of 50°C and current density 5 A/dm², using 100 g/l of a surfactant (product name: NC Lastoru, available from Okuno Chemical Industries Co., Ltd.). Then, after rinsing with water for several times, an activation process by acid was carried out by processing it using 5% of sulfuric acid for one minute at 25°C. Thereafter, it was rinsed with water for several times.

Next, conductive substrate 301 thus processed was electroplated by a rack plating apparatus under a condition of 28°C, current density 2.5 A/dm², and air-agitation, using copper sulfate plating liquid (containing 90 g/l of copper sulfate, 130 g/l of sulfuric acid, 50 ppm of chlorine and other addition agent), to obtain a first ground layer 304a made of Cu having a thickness of 1.5 µm thereon. Then, after rinsing with water for several times, first ground layer 304a was electroplated by the rack plating apparatus for four minutes under a condition of 55°C, pH 3.8, current density 4 A/dm², using nickel plating liquid (containing 240 g/l of nickel sulfate, 50 g/l of nickel chloride, and 40 g/l of boric acid), to obtain a second ground layer 304b made of Ni having a thickness of 1.8 µm thereon.

After rinsing with water for several times, second ground layer 304b was electroplated by the rack plating apparatus for five minutes under a condition of 60°C, pH 2.0, current density 1.5 A/dm², using ruthenium plating liquid (product name: Ru-33, available from NE Chemcat Corporation) of ruthenium concentration 8 g/l, to obtain a ruthenium layer 302 made of metal Ru having a thickness of 0.4 µm thereon.

Then, after rinsing with water for several times, it was further rinsed with 10% ammonia water (at 50°C for five minutes). Thereafter, an activation process by acid was carried out by processing it using 10% of hydrochloric acid for 0.5 minute at 25°C.

Next, after rinsing with water for several times, ruthenium layer 302 thus processed was electroplated by the rack plating apparatus for one minute under a condition of 35°C, pH 4.1, current density 1.2 A/dm², using gold plating liquid (product name: N77, available from NE Chemcat Corporation) of gold concentration 9 g/l, to obtain a surface metal layer 303 of a gold layer made of metal Au having a thickness of 0.1 µm thereon. Thus, the connector terminal of the present invention shown in Fig. 3 was obtained.

The connector terminal thus obtained had excellent connect resistance, ease of mating/unmating, and resistance to corrosion. Accordingly, the reliability of the connector having this connector terminal was extremely high.

### Example 4

Similarly to Example 3, the present example relates to a connector terminal in which a plurality of ground layers, a ruthenium layer and a gold layer as a surface metal layer are formed in this order on a conductive substrate. In the following, description will be given referring to Fig. 3.

First, as a conductive substrate 301, a tape-like phosphor bronze of a thickness of 0.1 mm is pressed into a shape of a connector to be a continuing connector terminal, and cut to have a length of 70 mm. After the cutting, degreasing process was carried out by cleaning conductive substrate 301 for three minutes at 53°C using 50 g/l of a surfactant (product name: ACE CLEAN 30, available from Okuno Chemical Industries Co., Ltd.). Then, after rinsing with water for several times, electrolytic degreasing process was carried out by cleaning it for two minutes, under a condition of 50°C and current density 5 A/dm², using 100 g/l of a surfactant (product name: NC Lastoru, available from Okuno Chemical Industries Co., Ltd.). Then, after rinsing with water for several times, an activation process by acid was carried out by processing it using 5% of sulfuric acid for one minute at 25°C. Thereafter, it was rinsed with water for several times.

Next, conductive substrate 301 thus processed was electroplated by a rack plating apparatus for four minutes under a condition of 55°C, pH 3.8, and current density 4 A/dm², using nickel plating liquid (containing 240 g/l of nickel sulfate, 50 g/l of nickel chloride, and 40 g/l of boric acid), to obtain a first ground layer 304a made of Ni having a thickness of 1.8 µm thereon. Then, after rinsing with water for several times, first ground layer 304a was electroplated by the rack plating apparatus for one minute under a condition of 48°C, pH 12.9, current density 1.0 A/dm², using silver plating liquid (containing 30 g/l of silver and 110 g/l of potassium cyanide), to obtain a second ground layer 304b made of Ag having a thickness of 0.6 µm thereon.

After rinsing with water for several times, second ground layer 304b was electroplated by the rack plating apparatus for five minutes under a condition of 60°C, pH 2.0, current density 1.5 A/dm², using ruthenium plating liquid (product name: Ru-33, available from NE Chemcat Corporation) of ruthenium concentration 8 g/l, to obtain a ruthenium layer 302 made of metal Ru having a thickness of 0.4 µm thereon.

Then, after rinsing with water for several times, it was further rinsed with 10% ammonia water (at 50°C for five minutes). Thereafter, an activation process by acid was carried out by processing it using 10% of hydrochloric acid for 0.5 minute at 25°C.

Next, after rinsing with water for several times, ruthenium layer 302 thus processed was electroplated by the rack plating apparatus for one minute under a condition of 35°C, pH 4.1, current density 1.2 A/dm², using gold plating liquid (product name: N77, available from NE Chemcat Corporation) of gold concentration 9 g/l, to obtain a surface metal layer 303 of a gold layer made of metal Au having a thickness of 0.1 µm thereon. Thus, the connector terminal of the present invention shown in Fig. 3 was obtained.

The connector terminal thus obtained had excellent connect resistance, ease of mating/unmating, and resistance to corrosion. Accordingly, the reliability of the connector having this connector terminal was extremely high.

### Example 5

The present example relates to a terminal in which a ruthenium layer and a surface metal layer are formed in this order on a conductive substrate. In the following, description will be given referring to Fig. 1.

First, as a conductive substrate 101, a tape-like nickel of a thickness of 0.1 mm is pressed into a shape of relay terminal to be a continuing relay terminal, and cut to have a length of 70 mm. After the cutting, degreasing process was carried out by cleaning conductive substrate 101 for three minutes at 53°C using 55 g/l of a surfactant (product name: ACE CLEAN 30, available from Okuno Chemical Industries Co., Ltd.). Then, after rinsing with water for several times, electrolytic degreasing process was carried out by cleaning it for two minutes, under a condition of 50°C and current density of 6.0 A/dm², using 120 g/l of a surfactant (product name: NC Lastoru, available from Okuno Chemical Industries Co., Ltd.). Then, after rinsing with water for several times, an activation process by acid was carried out by processing it using 6% of sulfuric acid for one minute at 30°C. Thereafter, it was rinsed with water for several times.

Next, a conductive substrate 101 thus processed was electroplated by a rack plating apparatus for five minutes under a condition of 62°C, pH 2.1, current density 1.6 A/dm², using ruthenium plating liquid (product name: Ru-33, available from NE Chemcat Corporation) of ruthenium concentration 8.5 g/l, to obtain a ruthenium layer 102 made of metal Ru having a thickness of 0.42 µm thereon.

Then, after rinsing with water for several times, it was further rinsed with 10% ammonia water (at 50°C for five minutes). Thereafter, an activation process by acid was carried out by processing it using 9% of hydrochloric acid for 0.5 minute at 30°C.

Next, after rinsing with water for several times, ruthenium layer 102 thus processed was electroplated by a rack plating apparatus for one minute under a condition of 37°C, pH 4.1, current density 1.3 A/dm², using gold plating liquid (product name: N77, available from NE Chemcat Corporation) of gold concentration 9.5 g/l, to obtain a surface metal layer 103 made of metal Au having a thickness of 0.11 µm thereon. Thus, the relay terminal of the present invention shown in Fig. 1 was obtained.

The relay terminal thus obtained had excellent connect resistance, resistance to heat, and resistance to corrosion. Accordingly, the reliability of the relay (part) having this relay terminal was extremely high.

### Example 6

The present example relates to a slide switch terminal in which a ground layer, a ruthenium layer and a surface metal layer are formed in this order on a conductive substrate. In the following, description will be given referring to Fig. 2.

First, as a conductive substrate 201, a tape-like phosphor bronze having a thickness of 0.1 mm is pressed into a shape of a slide switch terminal to be a continuing slide switch terminal, and cut to have a length of 70 mm. After the cutting, degreasing process was carried out by cleaning conductive substrate 201 for three minutes at 53 °C using 55 g/l of a surfactant (product name: ACE CLEAN 30, available from Okuno Chemical Industries Co., Ltd.). Then, after rinsing with water for several times, electrolytic degreasing process was carried out by cleaning it for two minutes, under a condition of 50°C and current density 6 A/dm², using 120 g/l of a surfactant (product name: NC Lastoru, available from Okuno Chemical Industries Co., Ltd.). Then, after rinsing with water for several times, an activation process by acid was carried out by processing it using 6% of sulfuric acid for one minute at 30°C. Thereafter, it was rinsed with water for several times.

Next, conductive substrate 201 thus processed was electroplated by a rack plating apparatus for one minute under a condition of 54°C, pH 3.8, current density 4.2 A/dm², using nickel plating liquid (containing 245 g/l of nickel sulfate, 45 g/l of nickel chloride, and 38 g/l of boric acid), to obtain a ground layer 204 made of Ni having a thickness of 0.98 µm thereon.

After rinsing with water for several times, ground layer 204 was electroplated by the rack plating apparatus for five minutes under a condition of 62°C, pH 2.1, current density 1.6 A/dm², using ruthenium plating liquid (product name: Ru-33, available from NE Chemcat Corporation) of ruthenium concentration 8.5 g/l, to obtain a ruthenium layer 202 made of metal Ru having a thickness of 0.42 µm thereon.

Then, after rinsing with water for several times, it was further rinsed with 10% ammonia water (at 50°C for five minutes). Thereafter, an activation process by acid was carried out by processing it using 9% of hydrochloric acid for 0.5 minute at 30°C.

Next, after rinsing with water for several times, ruthenium layer 202 thus processed was electroplated by the rack plating apparatus for one minute under a condition of 37°C, pH 4.1, current density 1.3 A/dm², using gold plating liquid (product name: N77, available from NE Chemcat Corporation) of gold concentration 9.5 g/l, to obtain a surface metal layer 203 made of metal Au having a thickness of 0.11 µm thereon. Thus, the slide switch terminal of the present invention shown in Fig. 2 was obtained.

The slide switch terminal thus obtained had excellent connect resistance, resistance to heat, and resistance to corrosion. Accordingly, the reliability of the slide switch (part) having this slide switch terminal was extremely high.

### Example 7

The present example relates to a terminal in which a plurality of ground layers, a ruthenium layer and a surface metal layer are formed in this order on a conductive substrate. In the following, description will be given referring to Fig. 3.

First, as a conductive substrate 301, a tape-like brass having a thickness of 0.1 mm is pressed into a shape of a relay to be a continuing relay terminal, and cut to have a length of 70 mm. After the cutting, degreasing process was carried out by cleaning conductive substrate 301 for three minutes at 53 °C using 55 g/l of a surfactant (product name: ACE CLEAN 30, available from Okuno Chemical Industries Co., Ltd.). Then, after rinsing with water for several times, electrolytic degreasing process was further carried out by cleaning it for two minutes, under a condition of 50°C and current density 6 A/dm², using 120 g/l of a surfactant (product name: NC Lastoru, available from Okuno Chemical Industries Co., Ltd.). Then, after rinsing with water for several times, an activation process by acid was carried out by processing it using 5% of sulfuric acid for one minute at 30°C. Thereafter, it was rinsed with water for several times.

Next, conductive substrate 301 thus processed was electroplated by a rack plating apparatus under a condition of 28°C, current density 2.5 A/dm², and air-agitation, using copper sulfate plating liquid (containing 100 g/l of copper sulfate, 140 g/l of sulfuric acid, 61 ppm of chlorine and other addition agent), to obtain a first ground layer 304a made of Cu having a thickness of 1.6 µm thereon. Then, after rinsing with water for several times, first ground layer 304a was electroplated by the rack plating apparatus for two minutes under a condition of 54°C, pH 3.8, current density 4.2 A/dm², using nickel plating liquid (containing 245 g/l of nickel sulfate, 45 g/l of nickel chloride, and 38 g/l of boric acid), to obtain a second ground layer 304b made of Ni having a thickness of 1.9 µm thereon.

After rinsing with water for several times, second ground layer 304b was electroplated by the rack plating apparatus for five minutes under a condition of 62°C, pH 2.1, current density 1.6 A/dm², using ruthenium plating liquid (product name: Ru-33, available from NE Chemcat Corporation) of ruthenium concentration 8.5 g/l, to obtain a ruthenium layer 302 made of metal Ru having a thickness of 0.42 µm thereon.

Then, after rinsing with water for several times, it was further rinsed with 10% ammonia water (at 50°C for five minutes). Thereafter, an activation process by acid was carried out by processing it using 9% of hydrochloric acid for 0.5 minute at 30°C.

Next, after rinsing with water for several times, ruthenium layer 302 thus processed was electroplated by the rack plating apparatus for one minute under a condition of 55°C, and current density 1.1 A/dm², using rhodium plating liquid (product name: Rh 225, available from NE Chemcat Corporation) of rhodium concentration 5.5 g/l , to obtain a surface metal layer 303 made of rhodium Rh having a thickness of 0.13 µm thereon. Thus, the relay terminal of the present invention shown in Fig. 3 was obtained.

The relay terminal thus obtained had excellent connect resistance, resistance to heat, and resistance to corrosion. Accordingly, the reliability of the relay (part) having this relay terminal was extremely high.

### Example 8

Similarly to Example 7, the present example relates to a slide switch terminal in which a plurality of ground layers, a ruthenium layer and a surface metal layer are formed in this order on a conductive substrate. In the following, description will be given referring to Fig. 3.

First, as a conductive substrate 301, a tape-like phosphor bronze having a thickness of 0.1 mm is pressed into a shape of a slide switch to be a continuing slide switch terminal, and cut to have a length of 70 mm. After the cutting, degreasing process was carried out by cleaning conductive substrate 301 for three minutes at 53 °C using 55 g/l of a surfactant (product name: ACE CLEAN 30, available from Okuno Chemical Industries Co., Ltd.). Then, after rinsing with water for several times, electrolytic degreasing process was carried out by cleaning it for two minutes, under a condition of 50°C and current density 6 A/dm², using 120 g/l of a surfactant (product name: NC Lastoru, available from Okuno Chemical Industries Co., Ltd.). Then, after rinsing with water for several times, an activation process by acid was carried out by processing it using 6% of sulfuric acid for one minute at 30°C. Thereafter, it was rinsed with water for several times.

Next, conductive substrate 301 thus processed was electroplated by a rack plating apparatus for two minutes under a condition of 54°C, pH 3.8, and current density 4.2 A/dm², using nickel plating liquid (containing 245 g/l of nickel sulfate, 55 g/l of nickel chloride, and 38 g/l of boric acid), to obtain a first ground layer 304a made of Ni having a thickness of 1.9 µm thereon. Then, after rinsing with water for several times, first ground layer 304a was electroplated by the rack plating apparatus for one minute under a condition of 48°C, pH 12.9, current density 1.0 A/dm², using silver plating liquid (containing 35 g/l of silver and 105 g/l of potassium cyanide), to obtain a second ground layer 304b made of Ag having a thickness of 0.7 µm thereon.

After rinsing with water for several times, second ground layer 304b was electroplated by the rack plating apparatus for five minutes under a condition of 62°C, pH 2.1, current density 1.6 A/dm², using ruthenium plating liquid (product name: Ru-33, available from NE Chemcat Corporation) of ruthenium concentration 8.5 g/l, to obtain a ruthenium layer 302 made of metal Ru having a thickness of 0.42 µm thereon.

Then, after rinsing with water for several times, it was further rinsed with 10% ammonia water (at 50°C for five minutes). Thereafter, an activation process by acid was carried out by processing it using 9% of hydrochloric acid for 0.5 minute at 30°C.

Next, after rinsing with water for several times, ruthenium layer 302 thus processed was electroplated by the rack plating apparatus for one minute under a condition of 37°C, pH 4.1, current density 1.3 A/dm², using gold plating liquid (product name: N77, available from NE Chemcat Corporation) of gold concentration 9.5 g/l, to obtain a surface metal layer 303 made of metal Au having a thickness of 0.11 µm. Thus, the slide switch terminal of the present invention shown in Fig. 3 was obtained.

The slide switch terminal thus obtained had excellent connect resistance, resistance to heat, and resistance to corrosion. Accordingly, the reliability of slide switch (part) having this slide switch terminal was extremely high.

### Example 9

The present example relates to a connector terminal in which a ruthenium layer and a surface metal layer are formed in this order on a conductive substrate. In the following, description will be given referring to Fig. 1.

First, as a conductive substrate 101, a tape-like nickel having a thickness of 0.1 mm is pressed into a shape of a connector terminal to be a continuing connector terminal, and cut to have a length of 70 mm. After the cutting, degreasing process was carried out by cleaning conductive substrate 101 for two minutes at 45 °C using 55 g/l of a surfactant (product name: ACE CLEAN 30, available from Okuno Chemical Industries Co., Ltd.). Then, after rinsing with water for several times, electrolytic degreasing process was further earned out by cleaning it for four minutes, under a condition of 43°C and current density of 5 A/dm², using 90 g/l of a surfactant (product name: NC Lastoru, available from Okuno Chemical Industries Co., Ltd.). Then, after rinsing with water for several times, an activation process by acid was carried out by processing it using 11% of sulfuric acid for one minute at 25°C. Thereafter, it was rinsed with water for several times.

Next, a conductive substrate 101 thus processed was electroplated by a rack plating apparatus for seven minutes under a condition of 65°C, 2.1, current density 1.2 A/dm², using ruthenium plating liquid (product name: Ru-33, available from NE Chemcat Corporation) of ruthenium concentration 8.5 g/l, to obtain a ruthenium layer 102 made of metal Ru having a thickness of 0.45 µm thereon.

Then, after rinsing with water for several times, it was further rinsed with 11% ammonia water (at 50°C for five minutes). Thereafter, an activation process by acid was carried out by processing it using 3% of hydrochloric acid for one minute at 31°C.

Next, after rinsing with water for several times, ruthenium layer 102 thus processed was electroplated by the rack plating apparatus for 1.5 minutes under a condition of 45°C, pH 4.0, current density 1.0 A/dm², using plating liquid of alloy containing gold (Au) (containing 5g/l of gold (Au) and 0.2g/l of cobalt; product name: N80, available from NE Chemcat Corporation) , to obtain a surface metal layer 103 made of an alloy containing gold (Au: 99.8 weight %, Co: 0.2 weight %) having a thickness of 0.11 µm thereon. Thus, the connector terminal of the present invention shown in Fig. 1 was obtained.

The connector terminal thus obtained had excellent connect resistance, ease of mating/unmating, resistance to heat, and resistance to corrosion. Accordingly, the reliability of connector having this connector terminal was extremely high.

### Example 10

The present example relates to a connector terminal in which a ground layer, a ruthenium layer and a surface metal layer are formed in this order on a conductive substrate. In the following, description will be given referring to Fig. 2.

First, as a conductive substrate 201, a tape-like phosphor bronze of a thickness of 0.1 mm is pressed into a shape of a connector terminal to be a continuing connector terminal, and cut to have a length of 70 mm. After the cutting, degreasing process was carried out by cleaning conductive substrate 201 for two minutes at 45°C using 55 g/l of a surfactant (product name: ACE CLEAN 30, available from Okuno Chemical Industries Co., Ltd.). Then, after rinsing with water for several times, electrolytic degreasing process was further carried out by cleaning it for four minutes, under a condition of 43°C and current density 5 A/dm², using 90 g/l of a surfactant (product name: NC Lastoru, available from Okuno Chemical Industries Co., Ltd.). Then, after rinsing with water for several times, an activation process by acid was carried out by processing it using 11% of sulfuric acid for one minute at 25°C. Thereafter, it was rinsed with water for several times.

Next, conductive substrate 201 thus processed was electroplated by a rack plating apparatus for two minutes under a condition of 49°C, pH 3.8, current density 4.2 A/dm², using nickel plating liquid (containing 235 g/l of nickel sulfate, 43 g/l of nickel chloride, and 35 g/l of boric acid), to obtain a ground layer 204 made of Ni having a thickness of 1.9 µm thereon.

After rinsing with water for several times, ground layer 204 was electroplated by the rack plating apparatus for seven minutes under a condition of 65°C, pH 2.1, current density 1.2 A/dm², using ruthenium plating liquid (product name: Ru-33, available from NE Chemcat Corporation) of ruthenium concentration 8.5 g/l, to obtain a ruthenium layer 202 made of metal Ru having a thickness of 0.44 µm thereon.

Then, after rinsing with water for several times, it was further rinsed with 11% ammonia water (at 50°C for five minutes). Thereafter, an activation process by acid was carried out by processing it using 3% of hydrochloric acid for one minute at 31°C.

Next, after rinsing with water for several times, ruthenium layer 202 thus processed was electroplated by the rack plating apparatus for 1.5 minutes under a condition of 45°C, pH 4.0, current density 1.0 A/dm², using plating liquid of alloy containing gold (Au) (containing 5g/l of gold (Au) and 0.2 g/l of cobalt; product name: N80, available from NE Chemcat Corporation), to obtain a surface metal layer 203 made of alloy containing gold (Au: 99.8 weight %; Co: 0.2 weight %) having a thickness of 0.12 µm. Thus, the connector terminal of the present invention shown in Fig. 2 was obtained.

The connector terminal thus obtained had excellent connect resistance, ease of mating/unmating, resistance to heat, and resistance to corrosion. Accordingly, the reliability of the connector having this connector terminal was extremely high.

### Example 11

The present example relates to a connector terminal in which a plurality of ground layers, a ruthenium layer and a surface metal layer are formed in this order on a conductive substrate. In the following, description will be given referring to Fig. 3.

First, as a conductive substrate 301, a tape-like brass having a thickness of 0.1 mm is pressed into a shape of a connector terminal to be a continuing connector terminal, and cut to have a length of 70 mm. After the cutting, degreasing process was carried out by cleaning conductive substrates 301 for two minutes at 45°C using 55 g/l of a surfactant (product name: ACE CLEAN 30, available from Okuno Chemical Industries Co., Ltd.). Then, after rinsing with water for several times, electrolytic degreasing process was further carried out by cleaning it for four minutes, under a condition of 43°C and current density 5 A/dm², using 90 g/l of a surfactant (product name: NC Lastoru, available from Okuno Chemical Industries Co., Ltd.). Then, after rinsing with water for several times, an activation process by acid was carried out by processing it using 11% of sulfuric acid for one minute at 25°C. Thereafter, it was rinsed with water for several times.

Next, conductive substrate 301 thus processed was electroplated by a rack plating apparatus under a condition of 32°C, current density 4.2 A/dm², and air-agitation, using copper sulfate plating liquid (containing 105 g/l of copper sulfate, 155 g/l of sulfuric acid, 58 ppm of chlorine and other addition agent), to obtain a first ground layer 304a made of Cu having a thickness of 1.5 µm thereon. Then, after rinsing with water for several times, first ground layer 304a was electroplated by the rack plating apparatus for two minutes under a condition of 49°C, pH 3.8, current density 4.2 A/dm², using nickel plating liquid (containing 235 g/l of nickel sulfate, 43 g/l of nickel chloride, and 35 g/l of boric acid), to obtain a second ground layer 304b made of Ni having a thickness of 1.9 µm thereon.

After rinsing with water for several times, second ground layer 304b was electroplated by the rack plating apparatus for seven minutes under a condition of 65°C, pH 2.1, current density 1.2 A/dm², using ruthenium plating liquid (product name: Ru-33, available from NE Chemcat Corporation) of ruthenium concentration 8.5 g/l, to obtain a ruthenium layer 302 made of metal Ru having a thickness of 0.46 µm thereon.

Then, after rinsing with water for several times, it was further rinsed with 11% ammonia water (at 50°C for five minutes). Thereafter, an activation process by acid was carried out by processing it using 3% of hydrochloric acid for one minute at 31°C.

Next, after rinsing with water for several times, ruthenium layer 302 thus processed was electroplated by the rack plating apparatus for one minute under a condition of 56°C, current density 1.0 A/dm², using rhodium plating liquid (product name: Rh225, available from NE Chemcat Corporation) of rhodium concentration 5.7 g/l, to obtain a surface metal layer 303 made of rhodium Rh having a thickness of 0.11 µm thereon. Thus, the connector terminal of the present invention shown in Fig. 3 was obtained.

The connector terminal thus obtained had excellent connect resistance, ease of mating/unmating, resistance to heat, and resistance to corrosion. Accordingly, the reliability of the connector having this connector terminal was extremely high.

### Example 12

Similarly to Example 11, the present example relates to a connector terminal in which a plurality of ground layers, a ruthenium layer and a surface metal layer are formed in this order on a conductive substrate. In the following, description will be given referring to Fig. 3.

First, as a conductive substrate 301, a tape-like phosphor bronze having a thickness of 0.1 mm is pressed into a shape of a connector terminal to be a continuing connector terminal, and cut to have a length of 70 mm. After the cutting, degreasing process was carried out by cleaning conductive substrate 301 for two minutes at 45 °C using 55 g/l of a surfactant (product name: ACE CLEAN 30, available from Okuno Chemical Industries Co., Ltd.). Then, after rinsing with water for several times, electrolytic degreasing process was carried out by cleaning it for four minutes, under a condition of at 43°C and current density of 5 A/dm², using 90 g/l of a surfactant (product name: NC Lastoru, available from Okuno Chemical Industries Co., Ltd.). Then, after rinsing with water for several times, an activation process by acid was carried out by processing it using 11% of sulfuric acid for one minute at 25°C. Thereafter, it was rinsed with water for several times.

Next, conductive substrate 301 thus processed was electroplated by a rack plating apparatus for two minutes under a condition of 49°C, pH 3.8, and current density 4.2 A/dm², using nickel plating liquid (containing 235 g/l of nickel sulfate, 43 g/l of nickel chloride, and 35 g/l of boric acid), to obtain a first ground layer 304a made of Ni having a thickness of 1.8 µm thereon. Then, after rinsing with water for several times, first ground layer 304a was electroplated by the rack plating apparatus for four minutes under a condition of 28°C, pH 12.9, current density 1 A/dm², using silver plating liquid (containing 45 g/l of silver and 105 g/l of potassium cyanide), to obtain a second ground layer 304b made of Ag having a thickness of 2.2 µm thereon.

After rinsing with water for several times, second ground layer 304b was electroplated by the rack plating apparatus for seven minutes under a condition of 65°C, pH 2.1, current density 1.2 A/dm², using ruthenium plating liquid (product name: Ru-33, available from NE Chemcat Corporation) of ruthenium concentration 8.5 g/l, to obtain a ruthenium layer 302 made of metal Ru having a thickness of 0.45 µm thereon.

Then, after rinsing with water for several times, it was further rinsed with 11% ammonia water (at 50°C for five minutes). Thereafter, an activation process by acid was carried out by processing it using 3% of hydrochloric acid for one minute at 31°C.

Next, after rinsing with water for several times, ruthenium layer 302 thus processed was electroplated by the rack plating apparatus for 0.5 minute under a condition of 40°C, pH 0.5, current density 5.0 A/dm², using plating liquid of alloy containing gold (Au) (containing 3.5 g/l of gold (Au) and 0.2 g/l of nickel (Ni) product name: N205, available from NE Chemcat Corporation), to obtain a surface metal layer 303 made of alloy containing gold (Au: 99.5 weight %, Ni: 0.5 weight %) having a thickness of 0.1 µm thereon. Thus, the connector terminal of the present invention shown in Fig. 3 was obtained.

The connector terminal thus obtained had excellent connect resistance, ease of mating/unmating, resistance to heat, and resistance to corrosion. Accordingly, the reliability of the connector having this connector terminal was extremely high.

### Example 13

The present example relates to a connector terminal in which a ruthenium layer is formed on a conductive substrate and a plurality of surface metal layers are formed thereon. In the following, description will be given referring to Fig. 4.

Through the procedure of Example 9 until forming a ruthenium layer on a conductive substrate and carrying out an activation process by acid, a connector terminal precursor was obtained in which a ruthenium layer 402 is formed on a conductive substrate 401.

Then, after rinsing with water for several times, the connector terminal precursor was set to a rack plating apparatus such that it is laterally laid in plating bath with exactly half of its area being soaked therein. Then, it was electroplated by the rack plating apparatus for 1.5 minutes under a condition of 45°C, pH 4.0, current density 1.0 A/dm², using plating liquid of alloy containing gold (Au) (containing 5g/l of gold (Au) and 0.2g/l of cobalt; product name: N80, available from NE Chemcat Corporation), to form a first surface metal layer 403a made of an alloy containing gold (Au: 99.8 weight %, Co: 0.2 weight %) having a thickness of 0. 1 µm on half portion of ruthenium layer 402.

Then, the connector terminal precursor was set upside down to the rack plating apparatus such that the portion of ruthenium layer 402 where first surface metal layer 403a has not formed can be processed. Thus, the connector precursor was electroplated by the rack plating apparatus for three minutes under a condition of 40°C, current density 4 A/dm², using tin (Sn) plating liquid (55 g/l of tin (Sn), 120 g/l of organic acid (product name: METASU AM, available from Yuken Industry Co., Ltd.), 30 cc/l of addition agent (product name: SBS-R, available from Yuken Industry Co., Ltd.)). Thereafter, it was rinsed three times with water, the surface was activated for one minute at 75°C using 10 g/l of sodium tertiary phosphate. Then, it was rinsed with pure water for five times, drained by air and dried for five minutes at 70°C. Thus, a second surface metal layer 403b made of tin (Sn) on the other half portion of ruthenium layer 402 was formed to obtain the connector terminal of the present invention shown in Fig. 4. The thickness of second surface metal layer 403b made of tin of the connector terminal was measured by the fluorescent X-ray coating thickness measurement system (available from Seiko Corporation), which was 4.9 µm.

The connector terminal thus obtained had excellent connect resistance, ease of mating/unmating, resistance to heat, and resistance to corrosion. Accordingly, the reliability of the connector having this connector terminal was extremely high. Further, with second surface metal layer 403b made of tin, it had excellent solderability as well.

### Comparative Example 1

A connector terminal was manufactured exactly according to Example 2, except that a ruthenium layer was not formed. Such a connector terminal has a structure in which an Ni layer and a gold layer as a surface metal layer are formed on a conductive substrate in this order, and corresponds to a conventional connector terminal.

### Comparative Example 2

A relay terminal was manufactured exactly according to Example 6, except that a terminal was to be a relay terminal and a ruthenium layer was not formed. Such a relay terminal has a structure in which an Ni layer and a gold layer as a surface metal layer are formed on a conductive substrate in this order, and corresponds to a conventional terminal.

### Comparative Example 3

A slide switch terminal was manufactured exactly according to Example 6, except that a ruthenium layer was not formed. Such a slide switch terminal has a structure in which an Ni layer and a gold layer as a surface metal layer are formed on a conductive substrate in this order, and corresponds to a conventional terminal.

### Comparative Example 4

A connector terminal was manufactured exactly according to Example 10, except that a ruthenium layer was not formed. Such a connector terminal has a structure in which an Ni layer and a surface metal layer are formed on a conductive substrate in this order, and corresponds to a conventional connector terminal.

### Comparative Example 5

A connector terminal was manufactured exactly according to Example 1, except that a layer made of ruthenium oxide having a thickness of 20nm was formed on a conductive substrate instead of the ruthenium layer made of metal ruthenium having a thickness of 0.4 µm.

The layer made of ruthenium oxide having a thickness of 20nm was formed on the conductive substrate through a reactive sputtering method in which metal ruthenium is sputtered in an oxygen atmosphere.

### Comparative Example 6

A connector terminal was manufactured by forming a layer made of ruthenium oxide on a conductive substrate in the same manner as Comparative Example 5 and forming thereon a gold layer having a thickness of 0.1 µm by the sputtering method.

In this Comparative Example 6, the thickness of the gold layer was determined to be 0.1 µm so as to be the same as that of the gold layer as the surface metal layer according to Example 1. With a gold layer having a thickness of 2 µm as in paragraph 0049 of Japanese Patent Laying Open No. 11-260178, it would be too thick that the comparison against the layers below, i.e., the layer made of ruthenium oxide and the layer made of metal ruthenium would be difficult. Accordingly, the thickness of the two was to be the same.

### Hardness Test

The terminals obtained by Examples 1-13 and the terminals obtained by Comparative Examples 1-6 were measured for the surface hardness at the surface of each surface metal layer under measurement load of 10g using a surface hardness meter (device name: Vickers surface hardness meter, available from Akashi Corporation). (The terminal of Example 13 was measured at the first surface metal layer). The results are shown in Table 1 below.

### Corrosion Resistance Test

The terminals obtained by Examples 1-13 and the terminals obtained by Comparative Examples 1-6 were tested for resistance to corrosion. The measurement condition was to spray 5% saline solution to observe the degree of corrosion after eight hours at 35°C. The terminal without corrosion was evaluated as "a", the terminal with small degree of corrosion was evaluated as "b", and the terminal with large degree of corrosion was evaluated as "c". The evaluation results are shown in Table 1 below.

**Table 1**

| | Terminal Type | Surface Hardness | Resistance to Corrosion |
|---|---|---|---|
| Example 1 | connector | 675HV | a |
| Example 2 | connector | 613HV | a |
| Example 3 | connector | 574HV | a |
| Example 4 | connector | 511HV | a |
| Example 5 | relay | 671HV | a |
| Example 6 | slide switch | 610HV | a |
| Example 7 | relay | 792HV | a |
| Example 8 | slide switch | 505HV | a |
| Example 9 | connector | 685HV | a |
| Example 10 | connector | 620HV | a |
| Example 11 | connector | 595HV | a |
| Example 12 | connector | 525HV | a |
| Example 13 | connector | 684HV | a |
| Comparative Example 1 | connector | 247HV | c |
| Comparative Example 2 | relay | 251HV | c |
| Comparative Example 3 | slide switch | 245HV | c |
| Comparative Example 4 | connector | 245HV | c |
| Comparative Example 5 | connector | N/A | c |
| Comparative Example 6 | connector | 249HV | c |

"N/A" indicates the case where surface metal layer easily falls off and thus the surface hardness could not be measured.

As can be seen from Table 1, as compared to the terminals obtained from Comparative Examples 1-6, the terminals obtained from Examples did not show falling off of the surface metal layers, due to their excellent surface hardness, and showed excellent resistance to corrosion in the corrosion resistance test. Among the terminals obtained from Examples, the connector terminals showed excellent ease of mating/unmating.

Further, as can be specifically seen from the results of Comparative Examples 5 and 6, the terminals where ruthenium oxide layers were formed instead of the ruthenium layers of the present invention could not attain high surface hardness and thus the surface metal layers were easy to fall off. Their resistance to corrosion was poor as well. From the results above, the excellent effect of the ruthenium layer of the present invention can be recognized.

Variations in the values of the surface hardness of the Examples are considered to be the effect of the conductive substrate or the ground layer exiting as the under layer of ruthenium layer, since the ruthenium layer singularly has a hardness of 700-850 HV but being relatively thin.

As above, the terminal of the present invention attains excellent surface hardness by forming the ruthenium layer as an under layer of the surface metal layer which results in the interaction between the ruthenium layer and the surface metal layer. Thus, wear or falling off of the surface metal layer is effectively prevented, excellent ease of mating/unmating is obtained while good connection resistance of the surface metal layer is maintained, and occurrence of pinhole is effectively prevented. Hence, quality such as high hardness, resistance to heat, and resistance to corrosion is drastically improved.

When two or more surface metal layers of different compositions are formed, the application of the terminal can further be widened.

Further, when a ground layer is formed as a lower layer of the ruthenium layer, the ruthenium layer is effectively prevented from falling off, irrespective of the type of the conductive substrate.

Still further, when the ground layer, ruthenium layer and surface metal layers are formed by plating method using any one of a barrel plating apparatus, a rack plating apparatus and a continuous plating apparatus, these layers can be formed extremely efficiently.

Accordingly, the part having the terminal of the present invention inherit the specific advantage of the terminal, having excellent contact resistance, ease of mating/unmating, resistance to heat, resistance to corrosion, and high reliability. Therefore, the part of the present invention can be widely applied to an electric or an electronic product, a semiconductor product, an automobile part and the like, suitably for both applications for mating/unmating application and not for mating/unmating.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A terminal, comprising:
a conductive substrate (101);
a ruthenium layer (102) formed on said conductive substrate (101) entirely or partially; and
a surface metal layer (103) made of at least one of the metals selected from the group consisting of Au, Pt, Ag, Pd, Rh, Co, Ni, In and Sn, or made of an alloy containing at least one of said metals, and formed on said ruthenium layer (102) entirely or partially.

2. The terminal according to claim 1, wherein
said ruthenium layer (102) is made of metal ruthenium or an alloy containing ruthenium.

3. The terminal according to claim 1, wherein
said surface metal layer (103) is a gold layer made of metal gold (Au).

4. The terminal according to claim 1, wherein
said terminal is any one of a connector terminal, a relay terminal, a slide switch terminal, and a soldering terminal.

5. The terminal according to claim 1, wherein
at least two surface metal layers (403a, 403b) having different compositions from each other are formed.

6. The terminal according to claim 1, further comprising
at least one ground layer (204) made of at least one of the metals selected from the group consisting of Ni, Cu, Au and Ag or made of an alloy containing at least one of said metals, and formed between said conductive substrate (201) and said ruthenium layer (202).

7. The terminal according to claim 6, wherein
said ground layer (304a, 304b), said ruthenium layer (302), and said surface metal layer (303) are formed by a plating method using any one of a barrel plating apparatus, a rack plating apparatus and a continuous plating apparatus.

8. A part having the terminal according to claim 1.

9. The part according to claim 8, wherein
said part is any one of a connector, a relay, a slide switch, a resistor, a condenser, a coil and a substrate.
